# EUROPEAN PATENT APPLICATION

(11) **EP 2 851 913 A1**
(43) Date of publication of application: **25.03.2015**
(21) Application number: 13803427.7
(22) Date of filing: 09.06.2013
(51) Int. Cl.: H01G 2/06, H05K 1/18

(54) **ELECTRICAL APPARATUS**

(30) Priority: 14.06.2012 CN 201220281269 U
(71) Applicant: Schneider Toshiba Inverter Europe SAS, 27120 Pacy sur Eure (FR)
(72) Inventor: CHEN, Jing, Shanghai 201203 (CN)
(74) Representative: Manitz, Finsterwald & Partner GbR
(86) International application number: PCT/CN2013/077031
(87) International publication number: WO 2013/185584

(57) **Abstract**

An electrical apparatus, comprising a circuit board, and a capacitor installed on the circuit board; the capacitor is detachably installed on the circuit board. The capacitor can be conveniently detached from the circuit board; therefore, a damaged capacitor can be easily replaced with a new capacitor, saving cost by avoiding the problem in the prior art that the entire electrical apparatus is discarded or causes downtime for repairs due to a damaged capacitor.

## Description

### Field of the Utility Model

The utility model relates to an electrical apparatus, and in particular relates to a structure for installing a capacitor in an electrical apparatus.

### Background of the Utility Model

Capacitors are a common electronic component in an electrical apparatus, and particularly, in the electrical apparatus such as a variable frequency driver, a plurality of bus capacitors are adopted. These bus capacitors are generally fixed on a bus circuit board by welding and the like, so that the bus capacitors are difficult to detach and replace.

Generally, the capacitors are distributed at different positions in the electrical apparatus, and a large amount of heat is generated when the electrical apparatus works. To achieve the purpose of dissipating the heat to the outside of the electrical apparatus, a forced cooling device such as a fan and the like is adopted. However, since the capacitors are generally away from the flowing path of cold air, some capacitors may not be well cooled. Meanwhile, the capacitors also emit heat during working. The accumulation of the heat leads to damage to or service life shortening of the capacitors.

Because the capacitors are generally welded on the circuit board, the capacitors may not be conveniently replaced particularly for a user of the electrical apparatus, and the entire electrical apparatus has to be replaced due to damage to the capacitors, thus causing unnecessary waste. Because the service lives of other components of the electrical apparatus are generally longer than the service lives of the capacitors, the service life of the entire electrical apparatus is determined by the capacitors.

To solve such a problem, in the prior art, proposed is a capacitor with high heat resistance or long service life. However, the cost of the capacitor with high heat resistance and long service life is obviously higher than that of a common capacitor, so that the cost of the entire electrical apparatus is increased.

Therefore, the installation structure for the capacitors needs to be improved.

### Summary of the Utility Model

The utility model is proposed in view of the above-mentioned problem of the prior art, and the aim of the utility model is to provide a novel capacitor installation structure. Through the installation structure, a capacitor may be easily installed on an electrical apparatus and easily detached from the electrical apparatus, and then when the capacitor is damaged, the damaged capacitor may be conveniently replaced, so that the service life of the entire electrical apparatus is prolonged, and the cost of the electrical apparatus is reduced.

According to an aspect of the utility model, provided is an electrical apparatus, including a circuit board and capacitors installed on the circuit board. The electrical apparatus is characterized in that the capacitors are detachably installed on the circuit board.

The capacitors may be conveniently detached from the circuit board by using the utility model, so that when one of the capacitors is damaged, the damaged capacitor may be easily replaced with a new capacitor, the condition in the prior art that the entire electrical apparatus is discarded or shut down for repairs due to damage to one capacitor is avoided, and therefore, the cost is saved.

The electrical apparatus further includes a shell, and an opening and a hatch cover for opening and closing the opening are formed at a position of the shell corresponding to the capacitors.

Since the special opening for replacing the capacitor is formed in the shell, the capacitor may be further conveniently replaced.

Preferably, two pins of each capacitor are arranged on the bottom surface in the capacitor opposite to the circuit board, and two connecting terminals detachably connected with the pins of the capacitor respectively are arranged on the circuit board, so that the capacitor is installed on the circuit board from top to bottom and electrically connected with the circuit board.

As an embodiment, the pins of the capacitor are in the form of connecting sheets extending out of the bottom surface of the capacitor, and the connecting terminals on the circuit board are in the form of elastic clamping terminals.

By using the pin form, the pins of the capacitors may be conveniently and electrically connected with the terminals on the circuit board.

As another embodiment, one pin of the capacitor is a cylindrical terminal extending out of the bottom surface of the capacitor, a thread is formed on the inner circumference or outer circumference of the cylindrical terminal, and the other pin is a columnar terminal extending out of the center of the cylindrical terminal on the bottom surface of the capacitor; and one of the connecting terminals on the circuit board is cylindrical, a thread capable of being engaged with the cylindrical terminal of the capacitor is formed on the outer circumference or inner circumference of the cylindrical connecting terminal, and the other one of the connecting terminals on the circuit board is a wiring track or an elastic terminal such as an elastic sheet on the circuit board and in the center of the circumferential connecting terminal.

A sleeve is also arranged on the circuit board, and the inner circumference of the sleeve is basically the same as the outer circumference of the main body of the capacitor in shape, so as to guide the capacitor to be installed on the circuit board. Through the sleeve serving as a guiding member, the capacitor may be further conveniently installed and detached.

The sleeve is provided with a step part, for determining the insertion position of the capacitor.

As an alternative form, the electrical apparatus may include a transfer element which is detachably installed on the circuit board, and the capacitor is installed on the transfer element.

The terminals of the existing capacitor may not be modified by using the transfer element, so that the cost of a product is reduced and the universality of the utility model is improved.

The transfer element is provided with two pins arranged on the bottom surface of the transfer element opposite to the circuit board, and the two pins of the transfer element are connected with the two pins of the capacitor installed thereon respectively and are detachably connected with the two connecting terminals on the circuit board respectively, so as to electrically connect the capacitor with the circuit board.

As an embodiment, the pins of the transfer element are in the form of connecting sheets extending out of the bottom surface of the capacitor, and the connecting terminals on the circuit board are in the form of elastic clamping terminals.

As another example, one pin of the transfer element is a cylindrical terminal extending out of the bottom surface of the transfer element, a thread is formed on the inner circumference or outer circumference of the cylindrical terminal, and the other pin is a columnar terminal extending out of the center of the cylindrical terminal on the bottom surface of the transfer element; and one of the connecting terminals on the circuit board is cylindrical, a thread capable of being engaged with the cylindrical terminal of the capacitor is formed on the outer circumference or inner circumference of the cylindrical connecting terminal, and the other one of the connecting terminals on the circuit board is a wiring track or an elastic terminal on the circuit board and in the center of the circumferential connecting terminal.

A sleeve is also arranged on the circuit board, and the inner circumference of the sleeve is basically the same as the outer circumference of the main body of the transfer element in shape, so as to guide the transfer element to be installed on the circuit board.

The sleeve is provided with a step part, for determining the insertion position of the transfer element.

### Brief Description of the Drawings

The above-mentioned and other features, objectives and advantages of the utility model will be clearer from the detailed description of preferred implementations of the utility model with reference to the accompanying drawings below, in which:
Fig. 1 is a perspective showing a variable frequency driver serving as an example of an electrical apparatus after a shell is removed;
Fig. 2 is a perspective showing the variable frequency driver shown in Fig. 1;
Fig. 3 is a perspective showing a state of the variable frequency driver shown in Fig. 2 when a closed capacitor hatch cover is opened;
Fig. 4 is a perspective showing that a capacitor is installed in a capacitor hatch of the variable frequency driver;
Fig. 5 is a schematic perspective showing an embodiment of a capacitor installation structure;
Fig. 6 is a schematic perspective showing the capacitor installation structure shown in

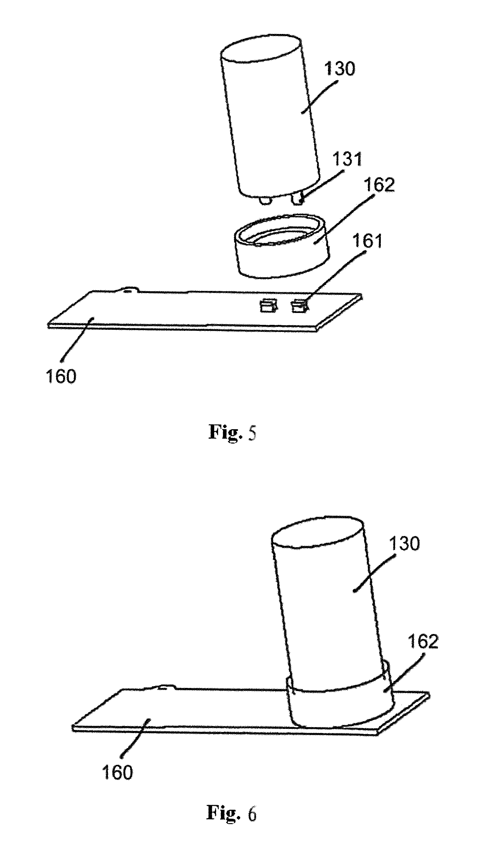

Fig. 5 after the capacitor is installed;

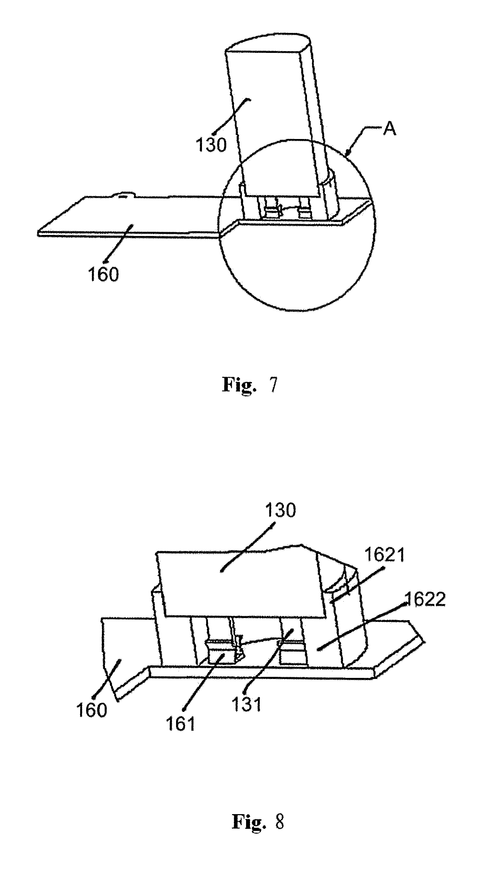

Fig. 7 is a half section view showing Fig. 6, for illustrating the capacitor installation structure;
Fig. 8 is an amplified view of a part surrounded by the circle A in Fig. 7;

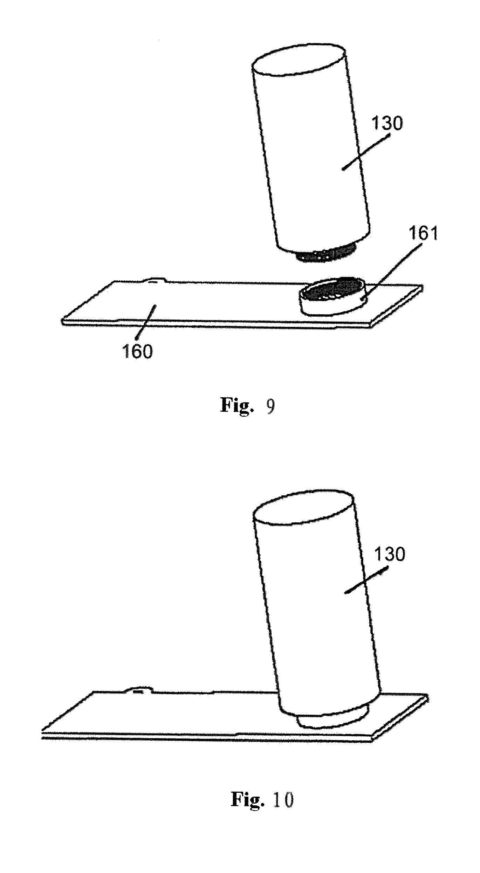

Fig. 9 is a schematic perspective showing another embodiment of the capacitor installation structure;
Fig. 10 is a schematic perspective showing the capacitor installation structure in Fig. 9 after the capacitor is installed;

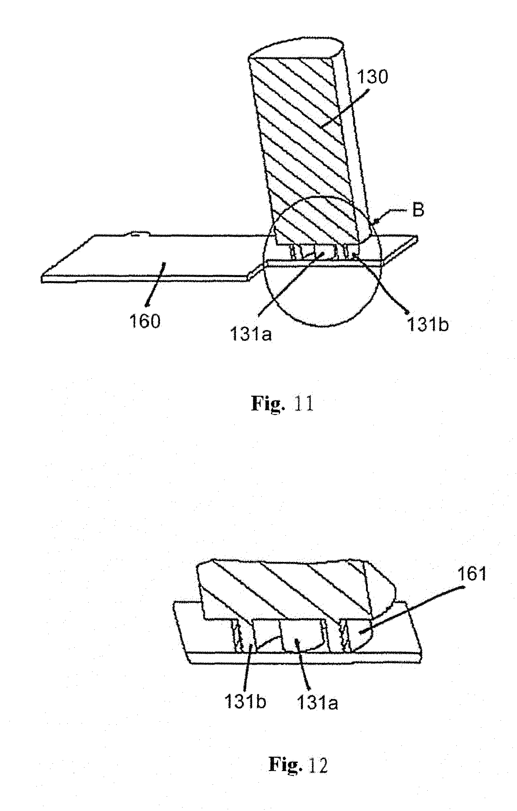

Fig. 11 is a half section view showing Fig. 10, for illustrating the capacitor installation structure; and
Fig. 12 is an amplified view of a part surrounded by the circle B in Fig. 11.

### Detailed Description of the Embodiments

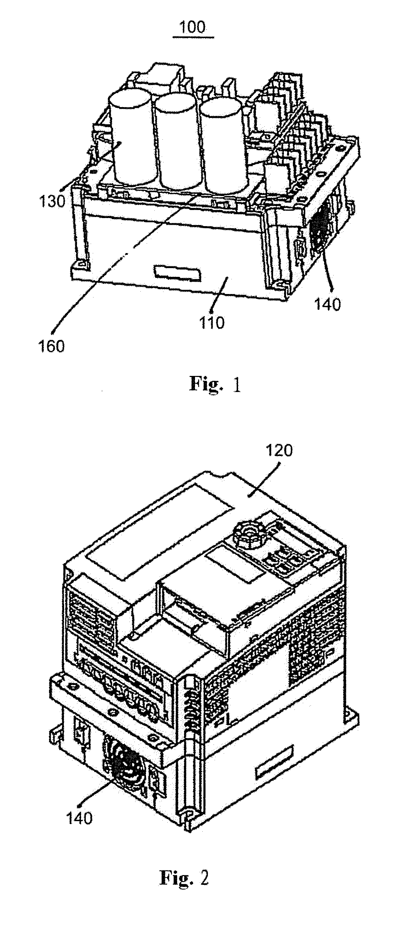

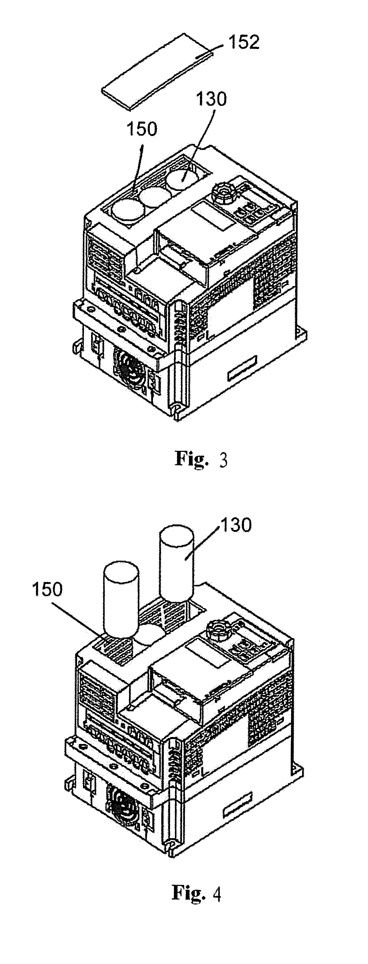

The preferred implementations of the utility model will be described in detail below with reference to Figs. 1 to 12. In the description below, a variable frequency driver is used as an example of an electrical apparatus, but it should be noted that, the utility model is not limited thereto, and may be applied to various electrical apparatuses including capacitors.

As shown in Figs. 1 to 4, the variable frequency driver 100 of the utility model includes a shell 110 and a base part 120, and all electronic devices including capacitors 130 are arranged in the base part 120 and covered by the shell 110. A fan 140 for sucking external cold air into the variable frequency driver 100 and cooling all the electronic devices is arranged at the bottom of the base part 120. A plurality of capacitors 130 are arranged on the same side of the base and detachably installed on a circuit board 160 (the capacitor installation structure will be described in detail below), and the shell 110 is installed on the base part 120 to form a capacitor hatch for accommodating the plurality of capacitors 130. An opening 150 is formed in the top of the capacitor hatch, namely in a part above the capacitors in the shell 110, and a hatch cover 152 serving as a part of the shell 110 is arranged on the opening 150 in an openable and closeable manner, so that the hatch cover 152 may be conveniently opened when a capacitor 130 is replaced. This openable and closeable structure may adopt multiple forms of fastening, hinging, sliding and the like, and these structures are well-known structures in this art, so they are not described in detail herein.

Heat dissipation holes for discharging hot air are formed in the side wall of the shell 110 corresponding to the capacitor hatch.

When one capacitor 130 fails, the hatch cover 152 may be opened, the damaged capacitor 130 may be taken out, and a new capacitor 130 may be installed on the circuit board, thus realizing replacement of the capacitor 130.

According to the utility model, the capacitor installation structure is designed in the form that the capacitors may be detachably connected with the circuit board 160 and positioned thereon, so that the capacitors 130 may be conveniently detached and installed. The first embodiment of the capacitor installation structure will be described in detail below with reference to Fig. 5 to Fig. 8.

As shown in Fig. 5 to Fig. 8, the capacitor 130 is roughly cylindrical and is provided with two pins 131 and 131 on the bottom surface thereof, the two pins 131 vertically extend out of the bottom surface, and the pins 131 are in the form of connecting sheets. Corresponding connecting terminals are arranged on the circuit board 160, the connecting terminals are in the form of elastic clamping terminals 161 and 161, and the two elastic clamping terminals 161 are connected with other corresponding electronic devices through wires (not shown) on the circuit board. A sleeve 162 is also fixed on the circuit board 160 and includes two parts 1621 and 1622 with different inner diameters, wherein the inner diameter of the large inner diameter part 1621 is basically the same as the outer diameter of the capacitor 130, so that a step part is formed between the large inner diameter part 1621 and the small inner diameter part 1622.

When the capacitor 130 is installed, the capacitor 130 is aligned with the sleeve 162 from the opening 150 of the capacitor hatch and inserted downwards vertically, so that the pins 131 of the capacitor 130 are inserted into the elastic clamping terminals 161, meanwhile, the main body of the capacitor 130 is inserted into the large inner diameter part 1621 of the sleeve 162, till the bottom end surface of the capacitor 130 presses against the step part formed between the large inner diameter part 1621 and the small inner diameter part 1622, thus ensuring that the pins 131 of the capacitor are electrically connected with the connecting terminals 161 on the circuit board and the large inner diameter part 1621 of the sleeve 162 plays a role in supporting and positioning the capacitor 130, and preventing the problem that the pins 131 and the connecting terminals 161 are damaged by over large downward force since the step part plays a role of a stop part.

To conveniently align the pins 131 of the capacitor 130 with the terminals 161 on the circuit board, guide ribs or guide grooves may be formed in the sleeve 162, and matched guide grooves or ribs are correspondingly formed in the cylindrical main body of the capacitor 130.

In addition, the sleeve 162 may not be formed on the circuit board but on other component nearby the capacitor, e.g. formed on the inner side wall of the shell 120. In addition, a stop member may also be separately formed on the circuit board 160, and the stop member does not need to be combined in the sleeve 162.

The second embodiment of the capacitor installation structure of the utility model will be described in detail below with reference to Fig. 9 to Fig. 12.

The difference between the second embodiment and the first embodiment lies in that: the sleeve 162 is removed, one connecting terminal 161 on the circuit board 160 is cylindrical, and the other connecting terminal (not shown) is formed on the circuit board and in the center of an area surrounded by the sleeve. An inner thread is formed on the inner circumference of the connecting terminal 161. As shown in Fig 12, the two pins 131a and 131b of the capacitor 130 are formed at the bottom end of the capacitor, the outer pin 131b is cylindrical, an outer thread is formed on the outer circumferential surface of the cylindrical outer pin 131b, and the inner pin 131 a is formed in the center of the inner part of the cylindrical outer pin 131b and protrudes outwards from the bottom surface of the capacitor 130 to a position which is as high as or slightly higher than the outer pin. When the capacitor 130 is installed, the outer pin 131b is engaged with the cylindrical connecting terminal 161 on the circuit board 160 and tightened, and meanwhile, the inner pin 131a presses against the connecting terminal formed on the circuit board. To ensure good contact between the inner pin 131 a and the terminal on the circuit board, the connecting terminal on the circuit board may be slightly raised on the circuit board, or in the form of an elastic sheet.

In addition, although the outer pin 131b of the capacitor 130 is provided with the outer thread as described above, it may also be provided with an inner thread, and the corresponding terminal 161 on the circuit board is provided with an outer thread, so that similar effects are achieved. In addition, although the inner pin is arranged in the center of the circle surrounded by the outer pin in the above description, the positioning of the inner pin in the center of the circle is practically not necessary, and the inner pin may deviate from the center, as long as the electrical insulation distance between the inner pin and the outer pin is ensured.

To guide and position the capacitor 130, a corresponding guiding and positioning mechanism may be arranged similarly, e.g. a large diameter sleeve similar to the sleeve 162 in the first embodiment may be additionally arranged on the outer side of the terminal 161, so as to play a role in guiding and stopping the capacitor 130.

By using each embodiment above, when one of the capacitors 130 is damaged, the damaged capacitor 130 may be conveniently taken down and replaced with a new capacitor, thus avoiding the problem in the prior art that the entire apparatus is discarded or shut down for repairs due to damage to one capacitor.

In addition, although the pin form of the capacitors in each embodiment above is different from that in the prior art, the capacitors may be customized in capacitor manufacturers as required. In addition, a transfer element in the form similar to that in each embodiment may be designed, and an existing capacitor may be directly installed on the transfer element to realize the form transfer of the terminal. For example, the transfer element is in the shape of the capacitor 130 in the first and second embodiments, the capacitor in the prior art may be installed in the transfer element and appropriately fixed, and the pins of the capacitor in the prior art are connected with the pins of the transfer element through internal wires and the like. In this way, as long as this transfer element is additionally prepared, any modification to the capacitor in the prior art may be avoided, so that the purpose of saving the cost is achieved.

In addition, although the utility model is described in detail above with reference to the preferred implementations of the utility model, it should be understood that the utility model is not limited thereto and various improvements may be made. For example, the capacitors 130 are not necessarily cylindrical and may be in any shape, and the capacitors 130 are not necessarily positioned on the same side, as long as corresponding openings and openable cover plates are arranged according to the specific positions of the capacitors 130, or an opening and a cover plate are only arranged on the capacitor 130 which is easily damaged, e.g. on the capacitor 130 at a position with the poorest heat dissipation condition, so that the capacitor 130 which is easily damaged may be conveniently replaced. Even, the opening is not needed, and the shell of the electrical apparatus is taken down during replacement to directly replace the damaged capacitor so as to achieve the similar effects.

Accordingly, those skilled in the art could understand that various modifications, substitutions or variations may be made to the specific embodiments described herein based on the above description without departing from the essence and scope of the utility model or the features disclosed in the embodiments may be combined with each other to obtain another new embodiment, and these should fall into the protection scope of the utility model.

## Claims

1. An electrical apparatus (100), comprising a circuit board (160) and capacitors (130) installed on the circuit board, wherein the capacitors (130) are detachably installed on the circuit board (160).

2. The electrical apparatus (100) of claim 1, wherein the electrical apparatus further comprises a shell (120), and an opening (150) and a hatch cover (152) for opening and closing the opening are formed at a position of the shell corresponding to the capacitors.

3. The electrical apparatus of claim 1 or 2, wherein two pins (131; 131a and 131b) of each capacitor are arranged on the bottom surface in the capacitor opposite to the circuit board, and two connecting terminals (161) detachably connected with the terminals of the capacitor respectively are arranged on the circuit board (160).

4. The electrical apparatus of claim 3, wherein the pins (131) of the capacitor are in the form of connecting sheets extending out of the bottom surface of the capacitor, and the connecting terminals on the circuit board are in the form of elastic clamping terminals (161).

5. The electrical apparatus of claim 3, wherein one pin of the capacitor is a cylindrical terminal (131b) extending out of the bottom surface of the capacitor, a thread is formed on the inner circumference or outer circumference of the cylindrical terminal, and the other pin is a columnar terminal (131a) extending out of the inner part of the cylindrical terminal on the bottom surface of the capacitor; and
one of the connecting terminals on the circuit board is cylindrical (161), a thread capable of being engaged with the cylindrical terminal of the capacitor is formed on the outer circumference or inner circumference of the cylindrical connecting terminal, and the other one of the connecting terminals on the circuit board is arranged on the circuit board and at a position in the cylindrical connecting terminal corresponding to the columnar terminal of the capacitor.

6. The electrical apparatus of claim 5, wherein the other one of the connecting terminals on the circuit board (160) is a wire arranged on the circuit board or an elastic sheet arranged on the circuit board.

7. The electrical apparatus of claim 4, wherein a sleeve (162) is also arranged on the circuit board, and the inner circumference of the sleeve is basically the same as the outer circumference of the main body of the capacitor in shape, so as to guide the capacitor to be installed on the circuit board.

8. The electrical apparatus of claim 5, wherein a sleeve (162) is also arranged on the circuit board, and the inner circumference of the sleeve is basically the same as the outer circumference of the main body of the capacitor in shape, so as to guide the capacitor to be installed on the circuit board.

9. The electrical apparatus of claim 7, wherein the sleeve (162) is provided with a step part, for determining the insertion position of the capacitor.

10. The electrical apparatus of claim 8, wherein the sleeve (162) is provided with a step part, for determining the insertion position of the capacitor.

11. The electrical apparatus of claim 1 or 2, wherein the electrical apparatus comprises a transfer element which is detachably installed on the circuit board, and the capacitor is installed on the transfer element.

12. The electrical apparatus of claim 11, wherein the transfer element is provided with two pins arranged on the bottom surface of the transfer element opposite to the circuit board, and the two pins of the transfer element are connected with the two pins of the capacitor installed thereon respectively and are detachably connected with the two connecting terminals on the circuit board respectively, so as to electrically connect the capacitor with the circuit board.

13. The electrical apparatus of claim 12, wherein the pins of the transfer element are in the form of connecting sheets extending out of the bottom surface of the capacitor, and the connecting terminals on the circuit board are in the form of elastic clamping terminals.

14. The electrical apparatus of claim 12, wherein one pin of the transfer element is a cylindrical terminal extending out of the bottom surface of the transfer element, a thread is formed on the inner circumference or outer circumference of the cylindrical terminal, and the other pin is a columnar terminal extending out of the inner part of the cylindrical terminal on the bottom surface of the transfer element; and
one of the connecting terminals on the circuit board is cylindrical, a thread capable of being engaged with the cylindrical terminal of the capacitor is formed on the outer circumference or inner circumference of the cylindrical connecting terminal, and the other one of the connecting terminals on the circuit board is arranged on the circuit board and at a position in the circumferential connecting terminal corresponding to the columnar terminal of the transfer element.

15. The electrical apparatus of claim 14, wherein the other one of the connecting terminals on the circuit board is a wire arranged on the circuit board or an elastic sheet arranged on the circuit board.

16. The electrical apparatus of claim 13, wherein a sleeve (162) is also arranged on the circuit board, and the inner circumference of the sleeve is basically the same as the outer circumference of the main body of the transfer element in shape, so as to guide the transfer element to be installed on the circuit board.

17. The electrical apparatus of claim 14, wherein a sleeve is also arranged on the circuit board, and the inner circumference of the sleeve is basically the same as the outer circumference of the main body of the transfer element in shape, so as to guide the transfer element to be installed on the circuit board.

18. The electrical apparatus of claim 16, wherein the sleeve is provided with a step part, for determining the insertion position of the transfer element.

19. The electrical apparatus of claim 17, wherein the sleeve is provided with a step part, for determining the insertion position of the transfer element.
